# EUROPEAN PATENT SPECIFICATION

(11) **EP 0 751 510 B1**
(45) Date of publication and mention of the grant of the patent: **29.03.2000**
(21) Application number: 96304663.6
(22) Date of filing: 25.06.1996
(51) Int. Cl.: G11B 7/125, G11B 7/12

(54) **Optical pickup using vertical cavity surface-emitting laser diode**
Optische Abtastvorrichtung mit oberflächenemittierender Laserdiode mit vertikalem Resonator
Dispositif de lecteur optique utilisant une diode laser à émission de surface à cavité verticale

(30) Priority: 30.06.1995 KR 1904495
(43) Date of publication of application: 02.01.1997
(73) Proprietor: SAMSUNG ELECTRONICS CO., LTD., Suwon-city, Kyungki-do 441-373 (KR)
(72) Inventor: Shin, Hyun-kik, Suwon-city, Kyungki-do (KR); Yi, You-shin, Suwon-city, Kyungki-do (KR)
(74) Representative: Chugg, David John

(56) References cited:
- EP-A- 0 348 950
- EP-A- 0 390 445
- DE-A- 4 404 635
- US-A- 5 285 466
- PATENT ABSTRACTS OF JAPAN vol. 095, no. 010, 30 November 1995 & JP 07 192291 A (MATSUSHITA ELECTRIC IND CO LTD), 28 July 1995,

## Description

The present invention relates to an optical pickup, and more particularly, to an optical pickup employing a vertical cavity surface-emitting laser (VCSEL) diode as a light source.

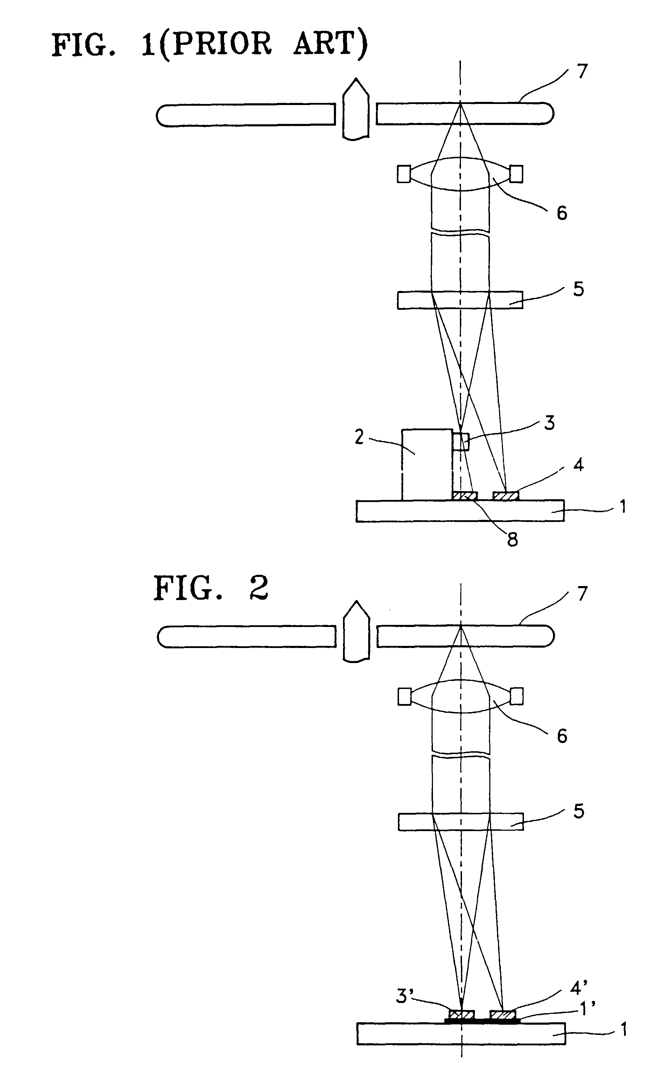

Figure 1 is a schematic diagram showing the arrangement of an optical system of a conventional hologram optical pickup used in a compact disk player. The conventional optical pickup comprises a printed circuit board (PCB) 1, a submount 2 installed on the PCB 1, an edge-emitting laser diode 3 fixed to the side of the submount 2 as a light source, a photo diode 8 fixed to the side of the submount 2 for sensing light output from the edge-emitting laser diode 3, a photodetector 4 installed on the PCB 1 for detecting the light emitted from the edge-emitting laser diode 3 and reflected from a disk 7, a hologram device 5 for transmitting the light emitted from the laser diode 3 and diffracting the light reflected from disk 7, and an object lens 6 for focusing the light from the hologram device 5 to enable information on a track of a disk 7 to be read.

The conventional optical pickup of a compact disk player as described above operates as follows. First, a laser beam, emitted from the laser diode 3 and having multiform polarization directions is changed into parallel light as the laser beam passes through the hologram device 5. The parallel light incident on the object lens 6 is focused and incident on a track of the disk. The laser beam incident on the track is reflected varying the polarization directions according to information recorded onto the track, passes through the object lens 6, and is incident on the hologram device 5. Here, the reflected light is diffracted to the photodetector 4 whereby signals for information loaded onto the disk, a focusing error, and a tracking error are detected.

However, due to the edge-emitting laser diode 3 being fixed to the submount 2 in the conventional optical pickup, the light axis is difficult to align with the hologram device 5. Also since a separate submount 2 and alignment of the photodetector 4 on the PCB is required, the assembly process is slowed.

Furthermore, the edge-emitting laser diode emits an oval light having large astigmatism, thus correctly detecting tracking error signals by the photodetector 4 is difficult and the intensity of light reaching the surface of the disk is lowered as the laser beam passes through the optical system.

It is an aim of preferred embodiments of the present invention to provide an optical pickup employing a light source and a photodetector integrated into a single chip to detect enough light reflected from an optical disk and having small astigmatism to reduce loss of light intensity in an optical system.

European Patent application No. EP 0,348,950 (Pencom International) discloses a hybrid surface emitting laser and detector, with the semiconductor laser and photodetector being provided in a single housing with the photodetector position to detect light emitted from the surface emitting laser and reflected off of a medium. The surface emitting laser is mounted on the top surface of a chip which includes at least one set of two photodetectors for detecting a reflected beam. At least two photodetectors are used so that spacial variations in the reflected beam can be detected for focusing and tracking when the device is used in an optical head, in this arrangement, the laser and photodetectors are of differing constructions but mounted on a single chip.

German patent application DE 4404635 (cf. the preamble of claim 1) (Hitachi) is an arrangement whereby a light source 1 and photodetector 7 are formed on the same substrate, however the light source and photodetectors are formed using different processing steps and their respective areas are treated in different fashion so that they are not of identical construction. By treating one area of the chip using different processing steps to the other areas of the chip, a relatively complex construction procedure is necessary.

According to an aspect of the present invention, there is provided an optical pickup, the optical pickup comprising: a light source formed of a VCSEL diode for emitting light toward an optical disk, said VSCEL diode used as said light source being formed of lower reflection mirror layers, a lower spacer layer on said lower reflection mirror layers, an activated layer on said lower spacer layer, an upper spacer layer on said activated layer and, upper reflection mirror layers on said upper spacer layer; a photodetector for detecting light reflected from said optical disk; a chip having said light source and said photodetector integrated thereon; a hologram device for changing light emitted from said light source in to polarized parallel light and for diffracting the light emitted from the disk to said photodetector; and an object lens for focusing the light transmitted from said hologram device on the optical disk, said optical pickup being characterised in that the photodetector is formed at the same time as the light source, using the same processing steps, and being of identical construction to the VCSEL diode of the light source but without a portion of or all of the upper reflection layers, that is, the photodetector is produced in the same process as the VCSEL diode so as to be constituted of lower reflection layers, a lower spacer layer on said lower reflection mirror layers, an activated layer on said lower spacer layer, an upper spacer layer on said activated layer and upper reflection mirror layers which are formed on said upper spacer layer of the photodetector, but a portion of or all of the upper reflection mirror layers being subsequently etched away.

Preferably, said photodetector is reverse biased with respect to said VCSEL diode.

The upper and lower may be reflection mirror layers of said chip may be formed of multiplex reflectors having multilayer structures.

For a better understanding of the invention, and to show how embodiments of the same may be carried into effect, reference will now be made, by way of example, to the accompanying diagrammatic drawings, in which:
Figure 1 is a schematic view of an optical system of a conventional hologram optical pickup;
Figure 2 is a schematic view of an optical system of an embodiment of a hologram optical pickup using a VCSEL diode suggested by the applicant;
Figure 3 is a perspective view of the VCSEL diode and a photodetector integrated into a single chip shown in Figure 2;
Figures 4A and 4B show output beams of an edge-emitting laser diode and a VCSEL diode, respectively;
Figure 5 is a magnified sectional view of the VCSEL diode of Figure 3;
Figure 6 is a schematic view of an exemplary embodiment optical system of a hologram optical pickup employing a VCSEL diode;
Figure 7 is a perspective view of the VCSEL diode and a photodetector shown in Figure 6 integrated into a single chip;
Figure 8 is a view showing vertical crystal growth of the VCSEL diode; and
Figure 9 is a view showing the intensity distribution of a sinusoidal wave in the middle portion of the VCSEL diode.

The optical pickup shown in Figure 2 comprises a VCSEL 3' and a photodetector 4' for detecting reflected light on a single chip 1' mounted on a PCB 1, a hologram device 5 for changing light emitted from the VCSEL diode 3' into parallel light and diffracting light reflected from a disk 7, and an object lens 6 for focusing the parallel light from the hologram device 5 onto a track of the disk 7.

The optical pickup of a compact disk player employing such a VCSEL diode operates as follows. First, a laser beam, emitted from the laser diode 3', having multiform polarization direction is changed into parallel light passing through the hologram device 5 and incident on the object lens 6. The parallel light incident on the object lens 6 is focused and incident on a track of the disk. When the polarized laser beam incident on the track is reflected from the disk, the polarization direction is varied according to information recorded on the track. Then, the beam passes through the object lens 6, and diffracts off the hologram device 5. The diffracted light is incident on the photodetector 4'. The photodetector 4' converts the diffracted beam from the disk 7 into electrical signals.

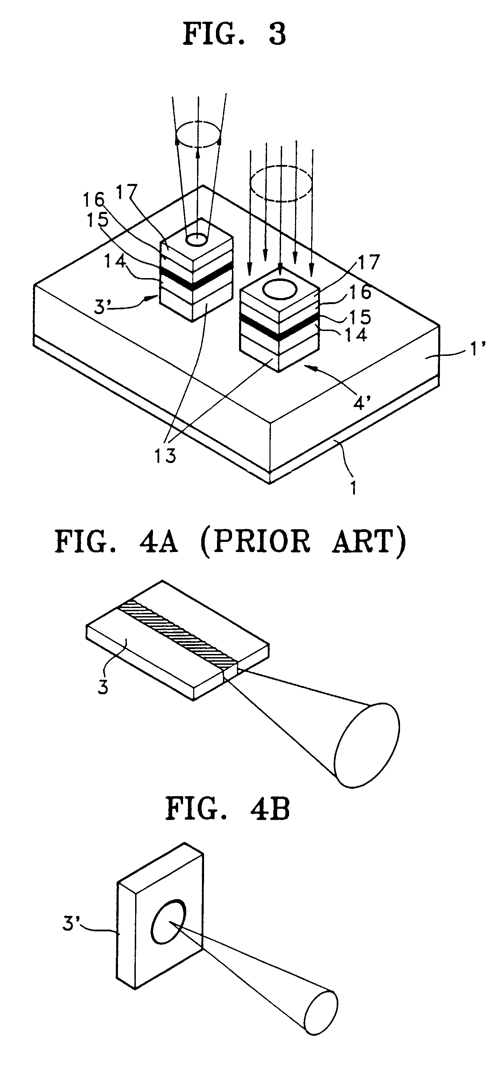

Tracking characteristics (detection of error) and focusing characteristics can be improved by using light of a single mode emitted from the VCSEL diode, having little astigmatism. Namely, as shown in Figure 4B, light emitted from the VCSEL diode 3', which is circular, has a single mode, and has less astigmatism than that of light emitted from the conventional edge-emitting laser diode 3 (Figure 4A), thereby reducing diffusion of light to lower light loss in an optical system.

In the optical pickup described above, productivity is improved since the light source 3' and the photodetector 4' are produced in a single process. Also, the light axes of the two devices can be controlled at the same time in an assembly process since the two devices are formed of identical VCSEL diodes. Namely, the VCSEL diode is not only used as a light source but also as a photodetector. The VCSEL diode is used as the photodetector by using an absorption increasing effect generated by applying a reverse bias voltage to the VCSEL diode and an absorption enhancement effect through multiple reflection mirrors for lasing to overcome decrease in a light absorption efficiency due to a thin absorbing layer of about 100Å. Accordingly, the light source and the photodetector have the same structure and share the same PCB, thereby allowing integration of the two devices into a single chip.

Figure 3 shows the VCSEL diode 3' and the photodetector 4' respectively, sharing the same structure and formed into a single chip. Here, a reverse bias voltage is applied to the photodetector 4' to prevent a laser from being emitted.

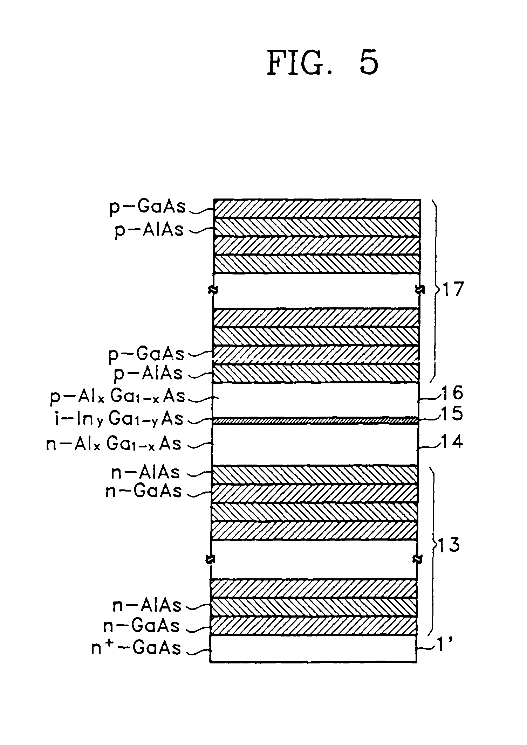

An MBE (molecular beam epitaxy) type VCSEL diode used as a light source and a photodetector in Figure 5 comprises lower reflection mirror layers 13 formed of n-GaAs layers and n-AlAs layers stacked alternately, a lower spacer layer 14 formed of n-AlₓGa₁₋ₓAs, an activated layer 15 of i-In_{y}Ga_{1-y}As, an upper spacer layer 16 of p-AlₓGa₁₋ₓAs, and upper reflection mirror layers 17 formed of p-AlAs layers and p-GaAs layers stacked alternately, stacked in the order described.

The MBE type surface-emitting laser diode is grown by an MBE method and roughly divided into two reflection mirrors and an activated layer as in a general laser diode. The activated layer 15, the light emitting portion, is formed of four GaAs quantum wells, each having a thickness of 100Å thus, 400Å thick as a whole, to emit light having a wavelength of 8500Å. The quantum wells can effectively contribute to a laser emitting mode by being located at a portion having maximum light wave amplitude in the middle of a Fabry-Perot cavity. The maximum gain of lasers available from the four quantum wells is about 0.01. Therefore, the reflection rates of the lower and upper reflection mirrors 13 and 17 should be at least 99%. Also, the lower reflection mirror 13 is Si-doped and the upper reflection mirror 17 is Be-doped (p type). In Be-doping, the upper portion is controlled to have a larger doping density than that of the lower portion. The laser emitting wavelength is determined by the thicknesses of the lower spacer 14 and the upper spacer 16.

An optical pickup using the above VCSEL diode has an advantage in that semiconductor devices used as a light source and a photodetector can be produced in a single process. However, the VCSEL diode used as a photodetector by applying a reverse bias voltage thereto includes a bragg mirror having a reflection rate of over 99.6% in the upper portion thereof. Thus, signal detection is difficult due to the lowered rate of reflected light from a disk reaching the activated layer of the photodetector.

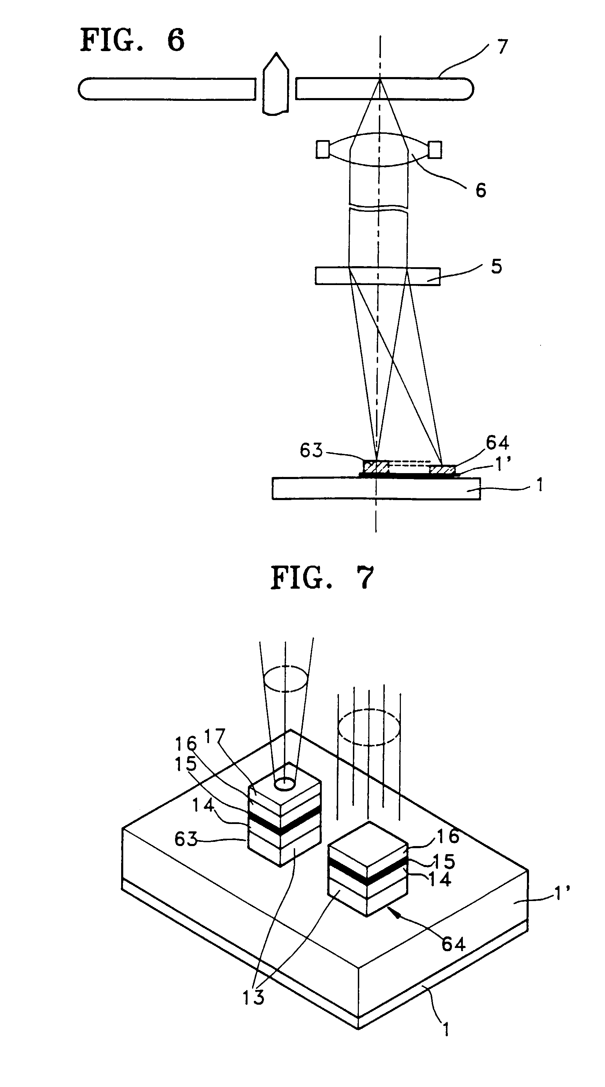

In Figures 6, 7, and 9, the same reference numerals as those of Figures 2, 3, and 5 represent the same elements.

Referring to Figure 6, a hologram optical pickup employing a surface-emitting laser diode according to an embodiment of the present invention comprises a PCB 1, a semiconductor substrate 1' on which a VCSEL diode 63 for use as a light source and a photodetector 64 are integrated, a hologram device 5, and a focusing lens 6. Figure 7 is a magnified perspective view of a device having a laser diode and a photodetector integrated into a single chip according to an embodiment of the present invention.

Referring to Figure 7, an MBE type surface-emitting laser diode 63 comprises lower reflection mirror layers 13 formed of n-GaAs layers and n-AlAs layers stacked alternately, a lower spacer layer 14 formed of n-AlₓGa₁₋ₓAs, an activated layer 15 of I-In_{y}Ga_{1-y}As, an upper spacer layer 16 of p-AlₓGa_{1-x,}As, and upper reflection mirror layers 17 formed of p-AlAs layers and p-GaAs layers, stacked in the order described.

As described above, the MBE type surface-emitting laser diode is grown by the MBE method and roughly divided into two reflection mirrors and an activated layer as in the general laser diode. The activated layer 15, the light emitting portion, is formed of four GaAs quantum wells each having a thickness of about 100Å thereby, 400Å thick as a whole, to emit light having a wavelength of 8500Å. The quantum wells can effectively contribute to a laser emitting mode by being located at a portion having maximum light wave amplitude in the middle of a Fabry-Perot cavity. The maximum gain of lasers available from the four quantum wells is about 0.01. Therefore, the reflection rates of the lower and upper reflection mirrors 13 and 17 should be at least 99%. Also, the lower reflection mirror layers 13 are Si-doped and the upper reflection mirror layers 17 are Be-doped (p type). In Be doping, the upper portion is controlled to have a larger doping density than that of the lower portion. The laser emitting wavelength can be determined by controlling the thicknesses of the lower spacer 14 and the upper spacer 16.

The photodetector 64 is formed by etching away a portion or all of the upper reflection mirror layers 17 from the VCSEL diode 63. By doing so, the intensity of light reaching the activated layer 15, which is changed into electric signals, can be increased by sharply reducing the reflection rate at the upper portions of the photodetector 64. By improving the sensitivity of the photodetector, the reliability of products is sharply increased; i.e., reproduction of information becomes more precise.

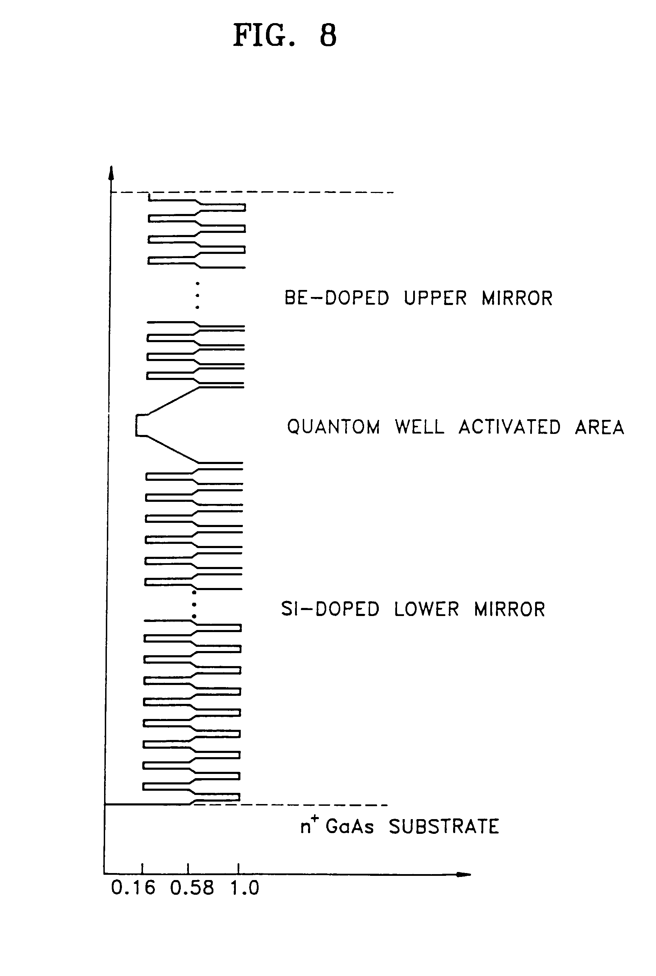

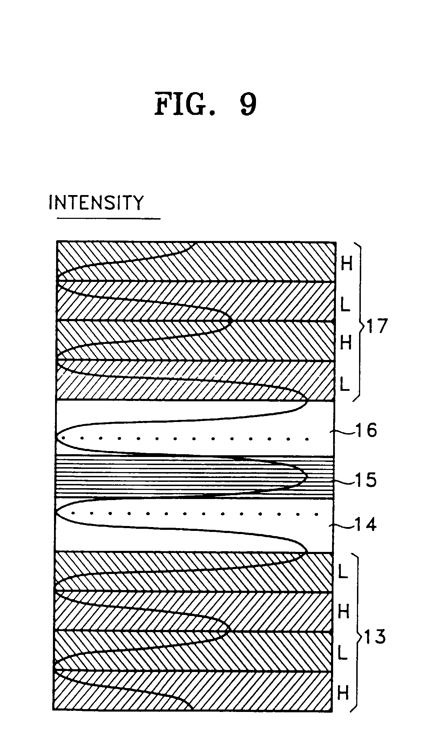

The vertical crystal growth of the VCSEL diode 63 used as a light source has the structure shown in Figure 8 and the vertical crystal growth of the surface-emitting laser diode used as the photodetector 64 has a structure wherein a portion or all of the upper Be-doping reflection mirror layers are removed from the structure shown in Figure 8. The distribution of intensity of a sinusoidal wave is shown in Figure 9.

As described above, in hologram optical pickups in accordance with embodiments of the present invention, it is possible to obtain a laser beam having little astigmatism and superior characteristics by removing a portion or all of the upper reflection mirror layers of the VCSEL diode for use as a photodetector. When the light source and the VCSEL-formed photodetector are integrated into a single chip, loss of light intensity of light reflected from a disk is sharply reduced.

## Claims

1. An optical pickup, the optical pickup comprising:
a light source formed of a VCSEL diode (3',63) for emitting light toward an optical disk (7), said VSCEL diode used as said light source (3',63) being formed of lower reflection mirror layers (13), a lower spacer layer (14) on said lower reflection mirror layers (13), an activated layer (15) on said lower spacer layer (14), an upper spacer layer (16) on said activated layer (15) and, upper reflection mirror layers (17) on said upper spacer layer (16);
a photodetector (4',64) for detecting light reflected from said optical disk (7);
a chip (1') having said light source (3',63) and said photodetector (4',64) integrated thereon;
a hologram device (5) for changing light emitted from said light source (3') in to polarized parallel light and for diffracting the light emitted from the disk (7) to said photodetector (4',64); and
an object lens (6) for focusing the light transmitted from said hologram device on the optical disk, said optical pickup being characterised in that the photodetector (4', 64) is formed at the same time as the light source, using the same processing steps, and being of identical construction to the VCSEL diode of the light source but without a portion of or all of the upper reflection layers (17), that is, the photodetector (4', 64) is produced in the same process as the VCSEL diode (3', 63) so as to be constituted of lower reflection layers (13), a lower spacer layer (14) on said lower reflection mirror layers (13), an activated layer (15) on said lower spacer layer (14), an upper spacer layer (16) on said activated layer (15) and upper reflection mirror layers (17) which are formed on said upper spacer layer (16) of the photodetector, but a portion of or all of the upper reflection mirror layers (15) being subsequently etched away.

2. An optical pick-up according to claim 1, wherein said photodetector (4', 64) is reverse biased with respect to said VCSEL diode (3', 63).

3. An optical pickup as claimed in claim 1 or 2, wherein the upper (17) and lower (16) reflection mirror layers of said chip (1') are formed of multiplex reflectors having multilayer structures.

## Patentansprüche

1. Optischer Aufnehmer, der umfaßt:
eine Lichtquelle, die aus einer VCSEL Diode (3', 63) zum Emittieren von Licht zu einer optischen Disk (7) gebildet ist, wobei die VSCEL Diode, die als die Lichtquelle (3', 63) verwendet wird, aus unteren Reflexionsspiegelschichten (13), einer unteren Abstandsschicht (14) auf den unteren Reflexionsspiegelschichten (13), einer aktivierten Schicht (15) auf der unteren Abstandsschicht (14), einer oberen Abstandsschicht (16) auf der aktivierten Schicht (15) und oberen Reflexionsspiegelschichten (17) auf der oberen Abstandsschicht (16) gebildet ist;
einen Photodetektor (4', 64) zum Detektieren von Licht, das von der optischen Disk (7) reflektiert wird;
einen Chip (1') auf den die Lichtquelle (3', 63) und der Photodetektor (4', 64) integriert sind;
eine Hologrammvorrichtung (5) zum Wandeln des von der Lichtquelle (3') emittierten Lichts in polarisiertes paralleles Licht und zum Beugen des von der Disk (7) emittierten Lichts zu dem Photodetektor (4', 64); und
eine Gegenstandslinse (6) zum Fokussieren des Lichts, das von der Hologrammvorrichtung auf die optische Disk transmittiert wird, wobei der optische Aufnehmer **dadurch gekennzeichnet** ist, daß der Photodetektor (4', 64) zur gleichen Zeit wie die Lichtquelle hergestellt wird, wobei die gleichen Prozeßschritte verwendet werden, und den gleichen Aufbau wie die VCSEL Diode der Lichtquelle aufweist aber ohne einem Teil oder ohne alle oberen Reflexionsschichten (17), das bedeutet, daß der Photodetektor (4', 64) im gleichen Prozeß wie die VCSEL Diode (3', 63) hergestellt wird, so daß er zusammengesetzt ist aus unteren Reflexionsschichten (13), einer unteren Abstandsschicht (14) auf den unteren Reflexionsspiegelschichten (13), einer aktivierten Schicht (15) auf der unteren Abstandsschicht (14), einer oberen Abstandsschicht (16) auf der aktivierten Schicht (15) und oberen Reflexionsspiegelschichten (17), die auf der oberen Abstandsschicht (16) des Photodetektors gebildet sind, wobei jedoch ein Teil oder alle oberen Reflexionsspiegelschichten (15) hinterher weggeätzt werden.

2. Optischer Aufnehmer gemäß Anspruch 1, wobei der Photodetektor (4', 64) in Bezug zu der VCSEL Diode (3', 63) entgegengesetzt vorgespannt wird.

3. Optischer Aufnehmer nach Anspruch 1 oder 2, wobei die oberen (17) und die unteren (16) Reflexionsspiegelschichten des Chips (1') aus Multiplexreflektoren mit Multilayerstrukturen gebildet sind.

## Revendications

1. Capteur de lecture optique, le capteur de lecture optique comportant :
une source lumineuse constituée d'une diode VCSEL (3', 63) destinée à émettre de la lumière en direction d'un disque optique (7), ladite diode VCSEL utilisée comme dite source lumineuse (3', 63) comportant des couches de miroir à réflexion inférieures (13), une couche d'interposition inférieure (14) sur lesdites couches de miroir à réflexion inférieures (13), une couche activée (15) sur ladite couche d'interposition inférieure (14), une couche d'interposition supérieure (16) sur ladite couche activée (15) et des couches de miroir de réflexion supérieures (17) sur ladite couche d'interposition supérieure (16) ;
un détecteur photoélectrique (4', 64) destiné à détecter la lumière réfléchie par ledit disque optique (7) ;
un circuit électronique (1') sur lequel sont intégrés ladite source lumineuse (3', 63) et ledit détecteur photoélectrique (4', 64) ;
un dispositif holographique (5) destiné à modifier la lumière émise par ladite source lumineuse (3') en lumière polarisée et à diffracter la lumière émise par le disque (7) vers ledit détecteur photoélectrique (4', 64) ; et
un objectif (6) destiné à focaliser la lumière émise par ledit dispositif holographique sur le disque optique, ledit capteur de lecture optique étant caractérisé en ce que le détecteur photoélectrique (4', 64) est formé simultanément à la source lumineuse, en utilisant les mêmes étapes de procédé, et étant de construction identique à la diode VCSEL de la source lumineuse, mais tout ou partie des couches de réflexion supérieures (17) étant absentes, à savoir, le détecteur photoélectrique (4', 64) est produit selon le même procédé que la diode VCSEL (3', 63) de manière à comporter des couches de réflexion inférieures (13), une couche d'interposition inférieure (14) sur lesdites couches de miroir à réflexion inférieures (13), une couche activée (15) sur ladite couche d'interposition inférieure (14), une couche d'interposition supérieure (16) sur ladite couche activée (15) et des couches de miroir de réflexion supérieures (17) qui sont formées sur ladite couche d'interposition supérieure (16) du détecteur photoélectrique, mais tout ou partie des couches de miroir de réflexion supérieures (15) étant ultérieurement éliminées par gravure.

2. Capteur de lecture optique selon la revendication 1, dans lequel ledit détecteur photoélectrique (4', 64) est polarisé en inverse par rapport à la diode VCSEL (3', 63).

3. Capteur de lecture optique selon la revendication 1 ou 2, dans lequel les couches de miroir à réflexion supérieures (17) et inférieures (16) dudit circuit électronique (1') sont formées de dispositifs réflecteurs multiples ayant des structures multicouche.
